# EUROPÄISCHE PATENTSCHRIFT

(11) **EP 1 392 879 B1**
(45) Veröffentlichungstag und Bekanntmachung des Hinweises auf die Patenterteilung: **24.11.2004**
(21) Anmeldenummer: 02754617.5
(22) Anmeldetag: 04.06.2002
(51) Int. Cl.: C23C 2/00

(54) **LICHTBOGEN-VERDAMPFUNGSVORRICHTUNG**
ELECTRIC ARC EVAPORATOR
EVAPORATEUR A ARC ELECTRIQUE

(30) Priorität: 05.06.2001 DE 10127013
(43) Veröffentlichungstag der Anmeldung: 03.03.2004
(73) Patentinhaber: Swiss-Plass.Com AG, 2540 Grenchen (CH); Gabriel, Herbert M., 64625 Bensheim (DE)
(72) Erfinder: CURTINS, Hermann, CH-2540 Grenchen (CH)
(74) Vertreter: Stoffregen, Hans-Herbert, Dr. Dipl.-Phys.
(86) Internationale Anmeldenummer: PCT/EP2002/006088
(87) Internationale Veröffentlichungsnummer: WO 2002/099152

(56) Entgegenhaltungen:
- DE-A- 4 329 155
- US-A- 4 724 058
- US-A- 5 298 136

## Beschreibung

Die Erfindung bezieht sich auf eine Lichtbogen-Verdampfungsvorrichtung umfassend eine Anode, ein als Kathode wirkendes oder mit dieser verbundenes Target, eine an die Anode und die Kathode angeschlossene Spannungsquelle zur Erzeugung eines Lichtbogens bzw. Lichtbogenspots auf dem Target bzw. dessen freier Oberfläche sowie unterhalb des Targets vorhandene eine innere und eine äußere Ringspule umfassende Magnetanordnung zur Erzeugung eines eine Lichtbogenbewegung auf der Targetoberfläche beeinflussenden Magnetfeldes.

Lichtbogen-Verdampfungsvorrichtungen werden z. B. zur Hartstoffbeschichtung von Substraten benutzt. Hierzu wird in einer Vakuumkammer durch einen auf ein aus Metall bestehendes Target auftreffenden Lichtbogen Targetmaterial verdampft, das mit in die Vakuumkammer eingeführten Reaktivgasen wie N2, C2H2 reagiert und sich auf dem Substrat niederschlägt. Besteht das Target z. B. aus Titan und wird der Vakuumkammer Stickstoff zugeführt, so kann sich auf zu beschichtendem Substrat TiN niederschlagen. Insoweit wird jedoch auf hinlänglich bekannte Verfahren verwiesen, genauso wie in Bezug auf anzulegende Spannung bzw. fließenden Strom, die im Bereich 10 bis 50 V bzw. bei Werten von mehr als 60 A liegen. In der Vakuumkammer selbst können Druckwerte von z. B. 0,0001 bis 0,1 mbar (10⁻² Pa bis 10 Pa) herrschen.

Die Stromführung zu der Kathode kann dabei unmittelbar zu dieser oder über eine Magnetspule erfolgen, um z. B. nach der DE 42 43 592 A1 den sich auf dem Target ausbildenden Lichtbogenspot entlang einer Random-Bahn zu bewegen.

In der EP 0 306 491 B1 wird eine Lichtbogen-Verdampfungsvorrichtung beschrieben, bei der ein Target zum Aufbringen einer Legierungsschicht auf ein Substrat benutzt wird, das zumindest zwei verschiedene Metalle in verschieden aktiven Flächenabschnitten des Targets aufweist.

Um auch bei großen Targetflächen eine gleichmäßige Erosion des Targetmaterials zu erreichen, wird nach der DE 35 28 677 C2 intermittierend über der Targetfläche ein Magnetfeld mit wenigstens einer geschlossenen Schleife erzeugt.

Eine Vorrichtung der eingangs genannten Art ist der DE 43 29 155 A1 zu entnehmen. Bei dieser Anordnung wird in einer Kombination aus vorzugsweise zwei Spulen zusammen mit einem in der Mitte angeordneten Permanentmagneten (von der inneren Spule umgeben) ein Magnetfeld an der Targetoberfläche so ausgebildet, dass die horizontale Komponente des Magnetfeldes über einen möglichst breiten Bereich der Targetbreite möglichst konstant ist. Damit wird einerseits erreicht, dass der Lichtbogen in geschlossenen Bahnen längs des Targets sich fortbewegt und in Querrichtung (parallel zur horizontalen Komponente des Magnetfeldes) keinen bevorzugten Ort auswählt und sich im zeitlichen Mittel in dieser Querrichtung überall mit gleicher Frequenz durchläuft. Man spricht in diesem Falle von "Controlled Arc in Lichtbogenlaufrichtung und Random Are in Querrichtung". Als Ziel wird eine gute Targetausnützung bzw. -erosion angestrebt. Die Nachteile einer solchen Anordnung sind im Folgenden zu sehen. Die Stärke des Anteils des Magnetfeldes herrührend durch den Permanentmagneten ändert sich mit der Erosion und kann nur sehr mühsam oder überhaupt nicht durch die Spulen korrigiert werden. Eine nicht optimale Targetausnützung ist die Folge.

Die Spannungs-Strom-Charakteristik kann bei fortschreitender Erosion nicht konstant gehalten werden und die abgeschiedenen Hartstoffschichten erleiden Änderungen in den Eigenschaften. Die Möglichkeit in der Variation der Magnetfeldstärke ist limitiert und somit können gewisse Schichteigenschaften nicht realisiert werden. Eine breite horizontale Charakteristik der horizontalen Magnetfeldkomponente begünstigt wegen des "Random-Arc Effekts" eine Aufzweigung des Lichtbogens mit der Folge von stärkeren Droplet-Emissionen und unerwünschten Schichtaufrauung. Ferner ist die Ansteuerung der Magnetfeldanordnung relativ komplex.

Bei allen bekannten Verdampfungsvorrichtungen ist es Ziel, die Magnetanordnung bzw. magnetische Einrichtung so zu gestalten, dass folgende Bedingungen beachtet bzw. folgende Kriterien erfüllt werden. Das von der magnetischen Einrichtung erzeugte Magnetfeld bildet mit seiner Horizontalkomponenten auf der Targetoberfläche eine geschlossene Bahn. Weist die Targetoberfläche eine Rechteckgeometrie auf, so ist die Magnetfeldbahn immer rechteckförmig mit abgerundeten Ecken. Entsprechende Feldgeometrien können mit Ringspulen (Elektromagneten), mit Permanentmagneten oder mit Kombinationen dieser erzielt werden. Dabei ist es wichtig, dass die Spannungs-Strom-Charakteristik des sich ausbildenden Lichtbogens, wobei der Strom fest vorgegeben und die Spannung vom vorhandenen Magnetfeld (durch Kontrollsystem veränderbarer Parameter), von den Bias-Spannungen, vom Druck, von der Gasart, etc. abhängt, auf dem Target in Abhängigkeit von dessen Material und Beschichtungsbedingungen optimal gewählt und eingestellt werden kann. Hierzu ist es erforderlich, dass die Magnetfeldstärke über einen großen Bereich veränderbar sein sollte. Dabei zeigen praktische Erfahrungen, dass die Magnetfeldstärke im Bereich von einigen Gauss bis etwa im Bereich von 200 Gauss (einige 10⁻⁴ T bis in etwa 2 x 10⁻² T) veränderbar ist: Des Weiteren ist es erforderlich, dass die horizontale Komponente des Magnetfeldes den gesamten Targetoberflächenbereich überstreichen kann, um das Targetmaterial optimal ausnutzen zu können. Dabei muss die Bewegung des Magnetfeldes entweder über die Ansteuerung der Spulen (statischer MAC, MAC = Magnetic Arc Confinement) oder über eine mechanische Bewegung des MAC realisiert werden. Dabei ist verständlicherweise die statische Magnetanordnung konstruktiv einfacher und damit preisgünstiger realisierbar.

Des Weiteren muss zur Erzielung reproduzierbarer Prozesse gewährleistet sein, dass über die gesamte Nutzdauer des Targets das Magnetfeld, d. h. dessen horizontale Komponente, das die Bewegung des Lichtbogens auf der Targetoberfläche vorgibt, in gewünschtem Umfang eingestellt werden kann. Dabei ist es von Vorteil, wenn die horizontale Komponente der Magnetfeldlinien einen steilen Abfall zeigt, um die Aufspaltung des Lichtbogens in mehrere Zweige zu unterdrücken, wodurch wiederum das Ausschlagen von Droplets (Tropfen) aus dem Target vermindert wird mit der Folge, dass die Rauigkeit der auf einem Substrat auszubildenden Schicht reduziert wird.

Der vorliegenden Erfindung liegt das Problem zu Grunde, die Möglichkeit einer Magnetfeldänderung der dem Target zugeordneten Magnetanordnung derart vorzunehmen, dass der Bereich des von dem Lichtbogen überstrichenen Bereichs des Targets vergrößert, also eine Erosionsgrabenverbreiterung ermöglicht wird. Gleichzeitig soll sichergestellt sein, dass der Lichtbogen auf vorgegebenen Bahnen bewegbar ist. Auch soll eine weitgehende Konstanz der Spannungsstrom-Charakteristik während der Gesamtnutzung des Targets zur Erzielung einer erhöhten Wirtschaftlichkeit erreicht werden.

Erfindungsgemäß wird das Problem im Wesentlichen dadurch gelöst, dass der zumindest einer der Ringspulen der Magnetanordnung ein im Bereich der Oberfläche des Targets das Magnetfeld der Ringspule beeinflussendes Element hoher relativer magnetischer Permeabilität (µr >> 1) zugeordnet ist, das sich entlang senkrecht oder im Wesentlichen senkrecht zur Oberfläche des Targets erstreckender Innen- oder Außenseite der Ringspule erstreckt. Insbesondere ist vorgesehen, dass das Element hoher relativer magnetischer Permeabilität die innere Ringspule peripher umschließt oder sich innenseitig entlang der äußeren Ringspule umlaufend erstreckt. Femer sollten die Ringspulen konzentrisch zueinander angeordnet sein.

Um das Magnetfeld der inneren Ringspule derart zu beeinflussen, dass das Maximum der horizontalen Feldkomponente in Richtung Targetmitte verschoben wird, sieht die Erfindung vor, dass die innere Ringspule peripher von dem Element hoher relativer magnetischer Permeabilität umschlossen ist. Durch einen so ausgebildeten einen magnetischen Kurzschluss bewirkenden Polschuh wird folglich verhindert, dass die Feldlinien in Richtung der äußeren Ringspule verschoben werden.

In Bezug auf die äußere Ringspule verläuft das Element hoher relativer magnetischer Permeabilität zwischen Außenspule und Innenspule, also innenseitig entlang der äußeren Ringspule, durch das das Magnetfeld der äußeren Ringspule nach außen abgedrängt wird. Somit ist durch die als Polschuhe zu bezeichnenden Elemente hoher relativer magnetischer Permeabilität erfolgten Magnetfeldverlaufsänderungen die Möglichkeit gegeben, die horizontalen Komponenten der Magnetfelder derart auf die Targetoberfläche auszurichten, dass diese über einen großen Bereich von dem Lichtbogen überstrichen werden kann.

Bei dem Element hoher relativer magnetischer Permeabilität handelt es sich um ein solches aus magnetischem Material wie Eisen bzw. Stahl oder Eisenlegierungen wie Permalloy. Dabei sollte das Element eine relative magnetische Permeabilität µr mit vorzugsweise µr ≥ 106 aufweisen.

Durch die erfindungsgemäße Lehre ist eine Erhöhung der Erosionsbreite in einem Target erzielbar, wodurch wiederum eine Steigerung der Produktivität einer entsprechenden Lichtbogen-Verdampfungsvorrichtung erreicht wird. Die technische Lösung ist konstruktiv einfach und kostengünstig. Da zudem eine stationäre, d. h. mechanisch nicht verstellbare Magnetanordnung genutzt wird, sind Störungen kaum zu befürchten. Permanentmagnete werden vermieden. Auch besteht die Möglichkeit, Magnetfeldstärken im Bereich von 10⁻⁵ T bis ohne Weiteres 10⁻² T oder höhere Werte zu erreichen.

Auch wenn die erfindungsgemäße Lehre bevorzugterweise mit einer Magnetanordnung mit innerer und äußerer Ringspule realisierbar ist, so besteht auch die Möglichkeit, eine Magnetanordnung mit nur einer Ringspule einzusetzen, der entsprechend der erfindungsgemäßen Lehre ein im Bereich der Oberfläche des Targets das Magnetfeld der Ringspule beeinflussendes Element hoher relativer magnetischer Permeabilität zugeordnet ist, wobei das Element die Ringspule peripher umgibt und die Magnetanordnung selbst in x- und/oder y-Richtung in einer parallel zur Targetoberfläche verlaufenden Ebene verstellbar ist. Gegebenenfalls kann auch eine Verstellung senkrecht zur Targetoberfläche, also zur z-Achse erfolgen.

Weitere Einzelheiten, Vorteile und Merkmale der Erfindung ergeben sich nicht nur aus den Ansprüchen, den diesen zu entnehmenden Merkmalen - für sich und/oder in Kombination - , sondern auch aus der nachfolgenden Beschreibung von der Zeichnung zu entnehmenden bevorzugten Ausführungsbeispielen.

Es zeigen:
- Fig. 1: eine Prinzipdarstellung einer Magnetanordnung mit zwei Ringspulen, von denen die innere Ringspule mit Strom beaufschlagt ist,
- Fig. 2: eine der Fig. 1 entsprechende Magnetanordnung mit strombeaufschlagter äußerer Ringspule,
- Fig. 3: die Magnetanordnung nach den Fig. 1 und 2 mit strombeaufschlagter innerer und äußerer Ringspule,
- Fig. 4: eine Magnetanordnung mit Ringspulen sowie Permanentmagneten,
- Fig. 5: eine Prinzipdarstellung einer erfindungsgemäßen Magnetanordnung mit strombeaufschlagter innerer Ringspule,
- Fig. 6: eine der Fig. 5 entsprechende Magnetanordnung mit strombeaufschlagter äußerer Ringspule,
- Fig. 6a: eine der Fig. 5 und Fig. 6 entsprechende Magnetanordnung mit strombeaufschlagten beiden Ringspulen,
- Fig. 7: typische Erosionsprofile erzielt mit Magnetanordnungen der Fig. 1 bis 6,
- Fig. 8: den Verlauf einer mit einer erfindungsgemäßen Anordnung erzeugten Magnetfeldstärke entlang der Oberfläche eines Targets,
- Fig. 9: eine perspektivische Darstellung einer ersten Ausführungsform einer Magnetanordnung,
- Fig. 10: die Magnetanordnung nach Fig. 9 in Draufsicht,
- Fig. 11: die Magnetanordnung nach den Fig. 9 und 10, jedoch geschnitten,
- Fig. 12: eine Draufsicht einer weiteren Ausführungsform einer Magnetanordnung und
- Fig. 13: die Magnetanordnung gemäß Fig. 12 in perspektivischer Darstellung und geschnitten.

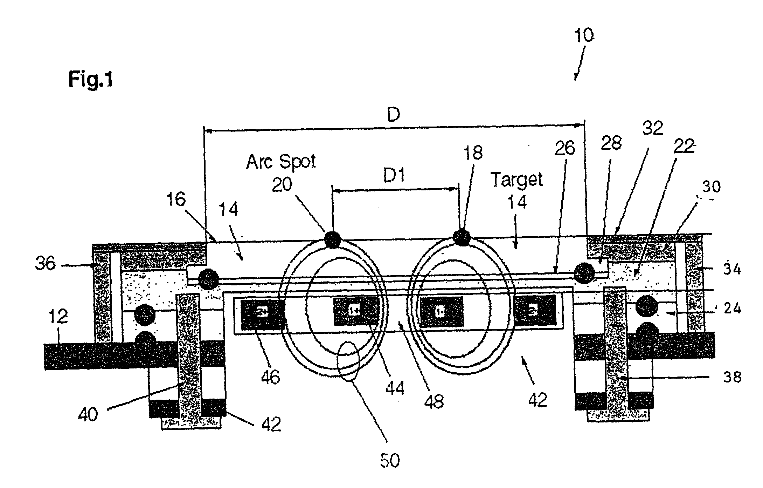

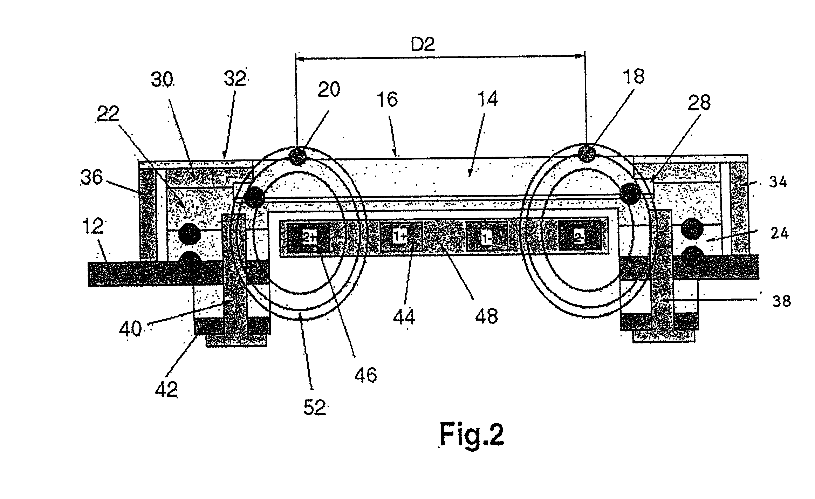

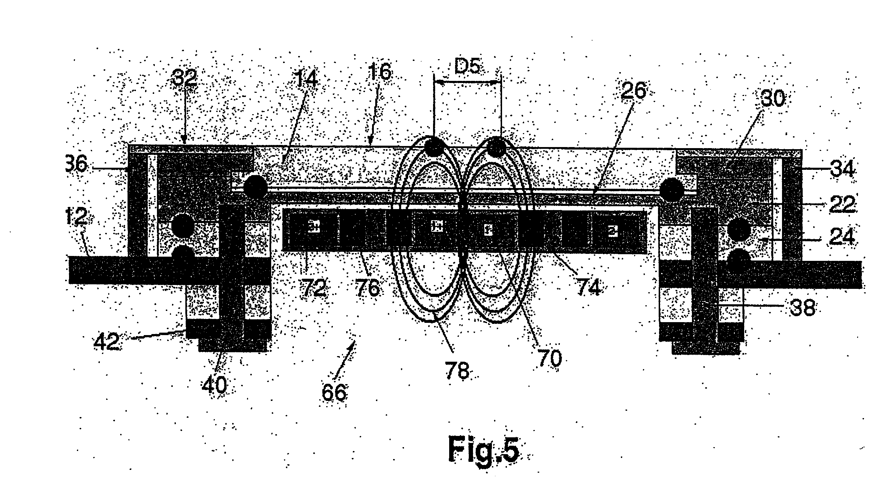

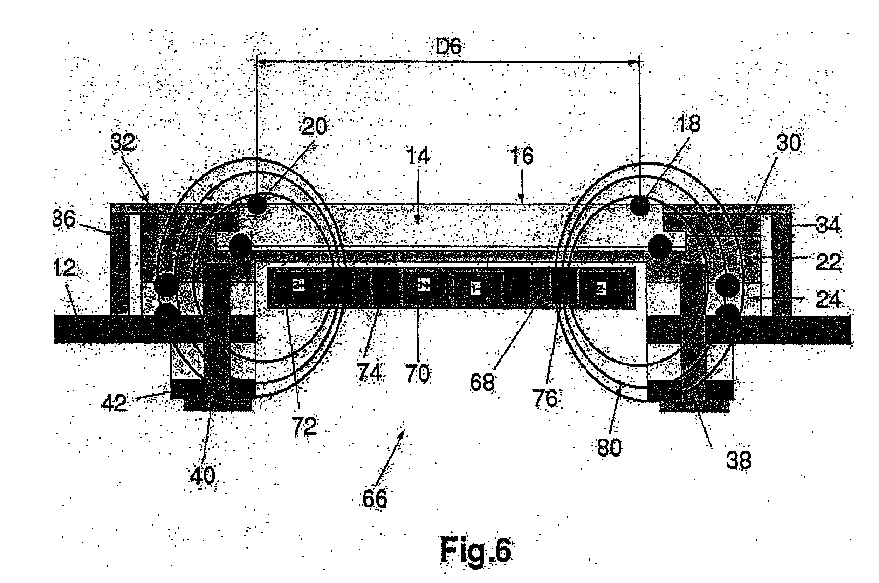

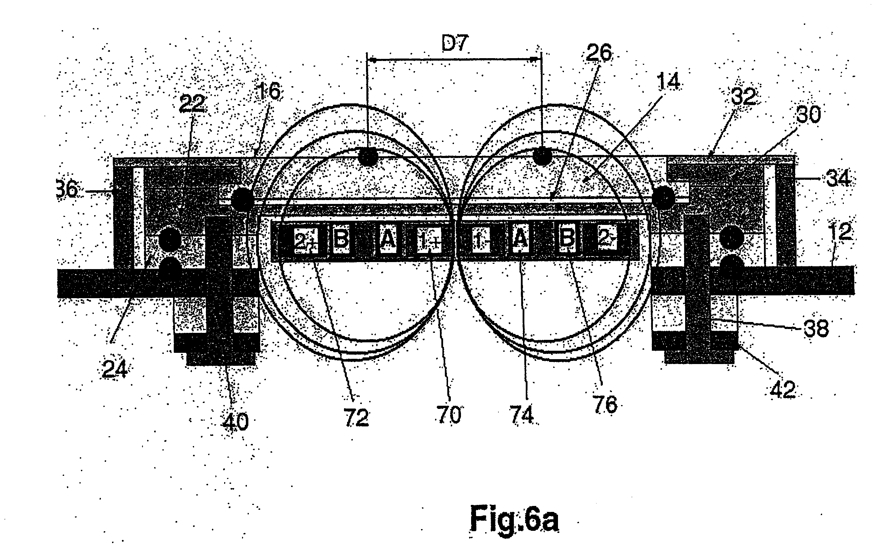

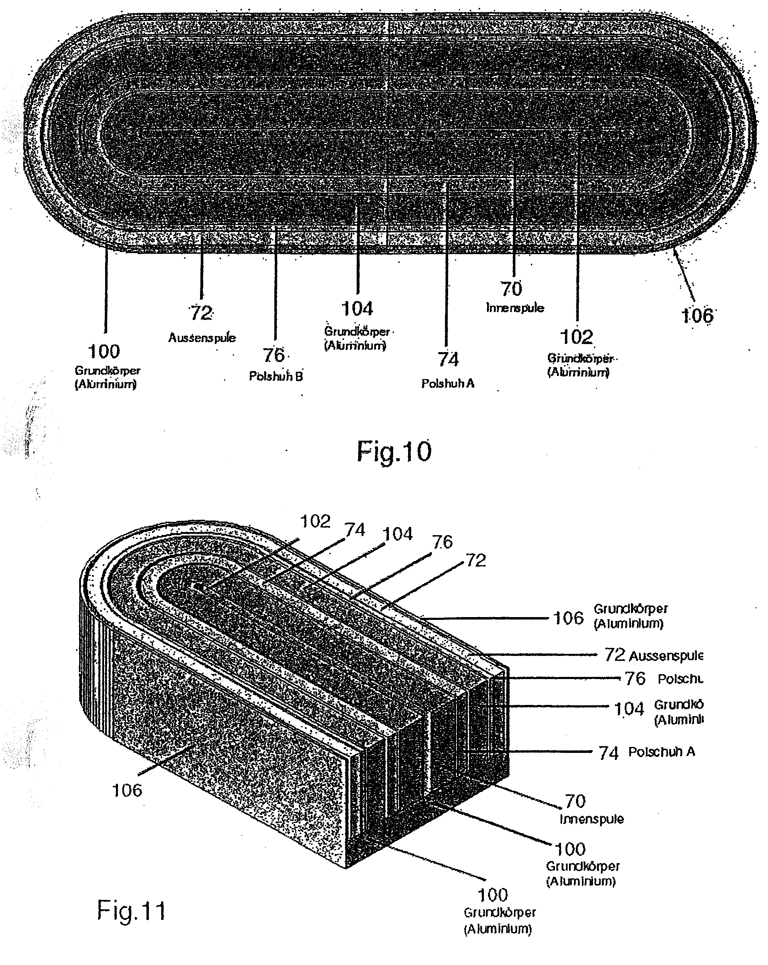

Anhand der Fig., in denen grundsätzlich gleiche Elemente mit gleichen Bezugszeichen versehen sind, sollen Magnetanordnungen bestimmt für Lichtbogen-Verdampfungsvorrichtungen beschrieben werden, die einerseits dem Stand der Technik entsprechen (Fig. 1 bis 5) und andererseits der erfindungsgemäßen Lehre (Fig. 6 bis 13) gehorchen. Unabhängig hiervon ist anzumerken, dass die anhand der Fig. prinzipiell dargestellten Anordnungen von Target und Stromzuführung eigenerfinderischen Gehalt aufweisen, auch wenn eine Erläuterung im Zusammenhang mit bekannten Magnetanordnungen erfolgt.

In den Fig. 1 bis 6 ist rein prinzipiell ein Kathodenkörper 10 dargestellt, der über eine Flanschplatte 12 in einem Gehäuse einer Vakuumkammer einer Lichtbogen-Verdampfungs-vorrichtung befestigbar ist. Dabei umfasst der Kathodenkörper 10 ein Target 14, dessen vakuumkammerseitig verlaufende freie Oberfläche (Targetoberfläche 16) mittels eines auf dieser zu bewegenden Lichtbogenspots 18 bzw. 20 verdampft wird. Das verdampfte Material reagiert sodann mit in die Vakuumkammer eingeführtem Reaktivgas wie z. B. N2 oder C2H2 und wird auf einem nicht dargestellten und in der Vakuumkammer befindlichen Substrat abgeschieden. Besteht das Target 14 z. B. aus Titan und wird in die Vakuumkammer Stickstoff eingeführt, so wird auf dem Substrat Titannitrid abgeschieden.

Zum Verdampfen von Targetmaterial wird zwischen dem Target 14 und dem Gehäuse der Vakuumkammer eine Spannung über eine Spannungsquelle angelegt, wobei das Gehäuse Anode und der Kathodenkörper 10 und damit das Target 14 Kathode sind. Insoweit wird auf hinlänglich bekannte Techniken verwiesen, genauso wie in Bezug auf die angelegte Spannung von in etwa in der Größenordnung 10 V bis 50 V und einem Strom von bevorzugterweise mehr als 60 A. Der Druck in der Vakuumkammer kann z. B. 0,0001 bis 0,1 bar (10-² Pa bis 10 Pa) je nach Anwendung betragen, um nur beispielhaft Werte zu nennen.

Entsprechend einer hervorzuhebenden Ausgestaltung geht das Target 14 von einem Träger 22 aus, der seinerseits über einen Isolator 24 gegenüber der Flanschplatte 12, die z. B. aus Aluminium besteht, elektrisch isoliert ist. Der Träger 22 und das Target 16 verlaufen zur Ausbildung eines Zwischenraumes 26 beabstandet zueinander, um diesen mit einem Kühlfluid zu beaufschlagen. Ferner weist das Target 14 einen umlaufenden bodenseitigen Flansch 28 auf, über den das Target 14 zwischen dem Träger 22 und einer oberhalb des Targets 14 verlaufenden Befestigungsplatte 30 fixiert ist. Die Befestigungsplatte 30 selbst ist von einem Isolator 32 z. B. aus BN abgedeckt und über Isolatoren 34, 36 mit der Grundplatte 12 verbunden.

Das Target 14 bzw. der Träger 22 ist über Bolzen, Schrauben oder gleichwirkende Elemente 38, 40 mit einem elektrischen Anschluss 42, insbesondere in Form eines Ringleiters verbunden, der zu der Spannungsquelle führt.

Damit ein bei zwischen der Anode und der Kathode angelegter Spannung sich ausbildender Lichtbogenspot 18, 20 auf der Oberfläche 16 des Targets 14 zum Materialabtrag dieses entlang einer vorgegebenen Bahn bewegt wird, ist unterhalb des Targets 14 und außerhalb der Vakuumkammer eine Magnetanordnung vorgesehen, wobei den Ausführungsbeispielen der Fig. 1 bis 4 solche zu entnehmen sind, die vom Stand der Technik her bekannt sind.

So ist in Fig. 1 eine Magnetanordnung 42 dargestellt, die zwei Ringspulen 44, 46 umfasst und die im Wesentlichen parallel in einer Ebene verlaufen, die sich parallel zur Oberfläche 16 des Target 14 erstreckt. Die Ringspulen 44, 46 sind von einem z. B. aus Kunststoff oder Aluminium bestehenden Gehäuse 48 aufgenommen. Die Halterung 48 und damit die Ringspulen 44 sind stationär angeordnet. Ferner verlaufen die Ringspulen 44, 46 - wie auch die nach der erfindungsgemäßen Lehre - konzentrisch zueinander und symmetrisch zur Längsachse des Targets 14. Insoweit wird jedoch auf bekannte Ringspulenanordnungen und -ausrichtungen verwiesen.

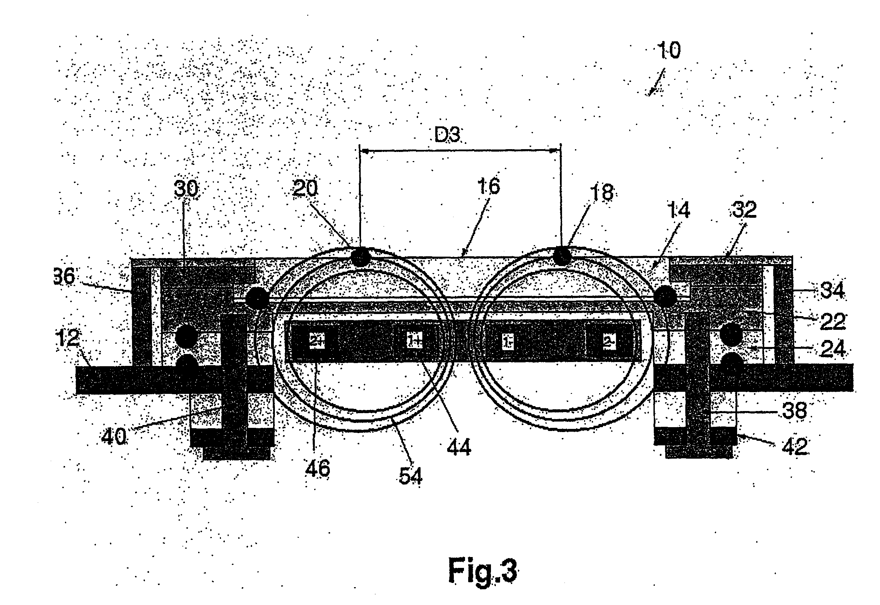

In Fig. 1 ist die innere Ringspule 44 mit Strom beaufschlagt, so dass der Maxima der horizontalen Komponenten der Magnetfeldlinien 50 einen Abstand D1 aufnehmen. Wird bei der der Fig. 1 zu entnehmenden Anordnung die äußere Ringspule 46 bei abgeschalteter inneren Ringspule 44 mit Strom beaufschlagt, so ist der Abstand der Maxima der horizontalen Komponenten der Magnetfeldlinien 52 D2. In Fig. 3 sind beide Ringspulen 44, 46 mit Strom beaufschlagt, so dass sich ein Maximum der horizontalen Komponente der Magnetfeldlinien 54 im Abstand D3 ergibt, wobei erkennbar D2 ≥D 3 ≥ D1 ist.

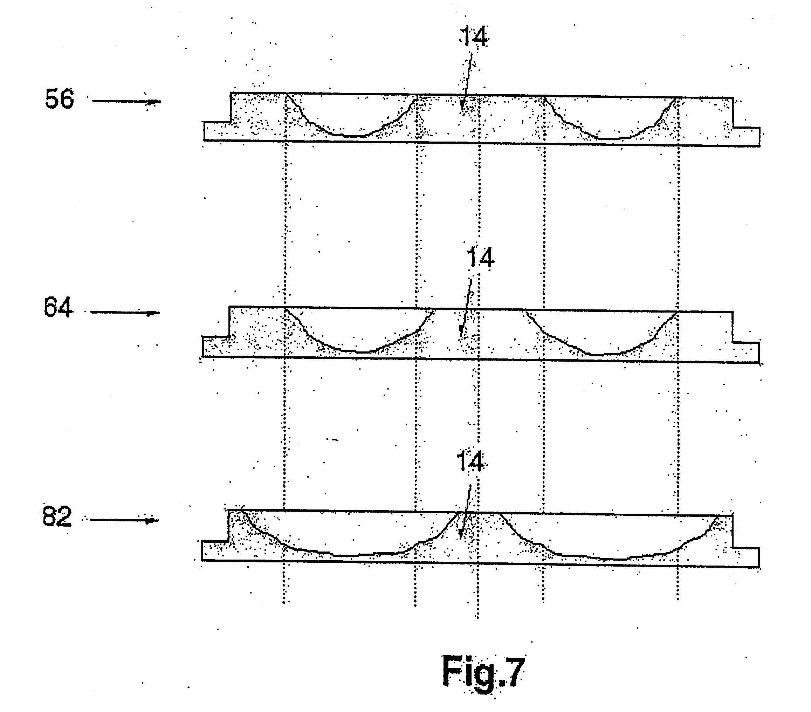

Somit kann eine durch den horizontalen Verlauf der Magnetfeldlinien vorbestimmte Bahn des Lichtbogenspots 18, 20 maximal den Bereich D2 - D1 bezogen auf die Breite D des Targets 14 erodieren mit der Folge, dass sich ein Erosionsprofil 56 der Fig. 7 in dem Target 14 ausbildet, und zwar durch entsprechendes Steuern der Spulen 44, 46. Differenz D2 - D1 ist im Vergleich zur Breite D des Targets 14 klein. Typische Werte belaufen sich auf D2 - D1 ≤ 0,5 D. Ursächlich für den schmalen erodierten Bereich des Targets ist, dass die Feldlinien der inneren Ringspule 44 in Richtung der äußeren Ringspule 46 gedrängt werden, da der Magnetfluss zwischen den Spulen 44 und 46 groß ist. Dies hat zur Folge, dass der Bereich D1 relativ groß ist. Zwar könnte versucht werden, den Abstand D1 durch Erzeugen großer Feldstärken mit der inneren Ringspule 44 zu reduzieren. Große Feldstärken bedeuten jedoch, dass die geometrische Ausdehnung der Ringspule vergrößert werden müsste, wodurch wiederum D 1 vergrößert werden würde.

Mit anderen Worten ergibt sich bei der stationären Magnetanordnung 42 gemäß der Fig. 1 - 3 ein relativ geringer Bereich der Targeterosion, so dass bei teuren Targetmaterialien hohe Produktionskosten zum Ausbilden von Schichten erwachsen.

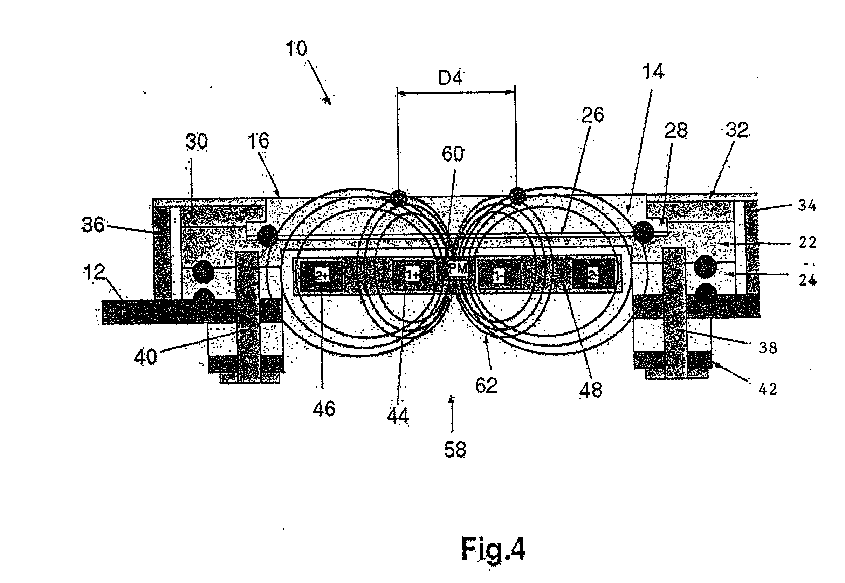

In Fig. 4 ist eine Ausführungsform einer Magnetanordnung 58 mit den Fig. 1 bis 3 entsprechendem Kathodenkörper 10 zu entnehmen, die neben zwei koaxial zueinander verlaufenden Ringspulen 44, 46 einen Permanentmagneten 60 aufweist, der von der inneren Ringspule 44 umschlossen wird und im Zentrum des Targets 14 angeordnet ist, wie dies durch die DE 43 29 155 A1 vorgeschlagen wird. Im Ausführungsbeispiel sind die Magnetfeldlinien 60 bei strombeaufschlagter innerer Spule 44 dargestellt, die durch Überlagerung des Magnetfeldes der innerer Spule 44 und des Magnetfeldes des Permanentmagneten 60 entstehen. Die Maxima der horizontalen Komponenten der Magnetfeldlinien 62 liegen im Abstand D4. Zwar ergibt sich eine Verbesserung der Differenz D2 - D4 bei nicht strombeaufschlagter innerer Spule 44 und angesteuerter äußerer Spule 46, wobei jedoch der Nachteil in Kauf zu nehmen ist, dass die Magnetfeldstärke des Permanentmagneten 60 grundsätzlich stets vorhanden ist und nur mit erheblichem Aufwand durch die Spulen 44, 46 kompensierbar ist. Somit ist die einzustellende Magnetfeldstärke eingeschränkt. In der Praxis hat sich gezeigt, dass bei fortgeschrittener Erosion eine Prozesskontrolle durch die Spulen 44, 46 nicht mehr im erforderlichen Umfang möglich ist, um reproduzierbare Ergebnisse zu erhalten mit der Folge, dass die Targets recht frühzeitig auszutauschen sind. Ein der Anordnung der Fig. 4 entsprechendes Erosionsprofil ist in der Fig. 7 mit dem Bezugszeichen 64 gekennzeichnet. Ein Vergleich mit dem Erosionsprofil 56 zeigt eine größere Breite des Erosionsgrabens.

Alternativ könnte einem Target ausschließlich eine einen Permanentmagneten aufweisende Magnetanordnung zugeordnet werden. In diesem Fall wäre es erforderlich, den Permanentmagneten zumindest in x und y in einer Ebene parallel zur Oberfläche des Targets zu bewegen. Eine zusätzliche Bewegung senkrecht zur Targetoberfläche 16, also in z-Richtung führt zu einer Veränderung der Magnetfeldstärke selbst und insbesondere dessen Verlauf.

Den Fig. 5 und 6 sind prinzipielle Magnetanordnungen 66 zu entnehmen, die der erfindungsgemäßen Lehre gehorchen.

Die Magnetanordnung 66 umfasst eine z. B. aus Kunststoff oder Aluminium bestehende Halterung 68, die eine innere Ringspule 70 und eine konzentrisch zu dieser verlaufende äußere Ringspule 72 aufnimmt. Die Ringspulen 70, 72 folgen in etwa der Geometrie des Targets 14 selbst und weisen in Draufsicht eine Rechteckform mit abgerundeten Ecken auf. Auch verlaufen die Ringspulen 70, 72 in einer Ebene, die sich parallel zur Oberfläche 16 des Targets 14 erstreckt. Ferner ist eine Symmetrie zur Längsachse des Targets 14 gegeben.

Abweichend von den bekannten Anordnungen wird die Innenspule 70 konzentrisch von einem umlaufenden Polschuh 74 aus einem ferromagnetischen Material wie Eisen bzw. Stahl oder eine Legierung wie Permalloy umgeben, also einem Material, das eine hohe relative magnetische Permeabilität µr mit µr insbesondere ≥ 104, vorzugsweise ≥ 106, aufweist.

Die äußere Ringspule 72 wird innenseitig ebenfalls von einem Polschuh 76 entsprechenden Materials begrenzt und der koaxial zu dem Polschuh 74 verläuft. In den Fig. 5 und 6 sind des Weiteren die Magnetfeldlinien bei allein eingeschalteter inneren Ringspule 70 bzw. allein eingeschalteter äußerer Ringspule 72 (Fig. 6) dargestellt.

Entsprechend der Darstellung der Fig. 5 ist erkennbar, dass der Abstand der Maxima der horizontalen Komponenten der von der inneren Ringspule 70 erzeugten Feldlinien 78 D5 beträgt, wohingegen der Abstand der Maxima der horizontalen Komponenten der Magnetfeldlinien 80 bei stromdurchflossener äußerer Ringspule 72 und abgeschalteter inneren Ringspule 70 den Wert D6 aufweist. Erkennbar ist die Differenz D6 - D5 erheblich größer als die Differenzen D2 - D1 gemäß Ausführungsbeispiel der Fig. 1 bis 3 und auch als die entsprechende Differenz nach Fig. 4. Somit ergibt sich ein breiteres Erosionsprofil 82 entsprechend der Fig. 7. Dies wiederum bedeutet, dass eine Steigerung der Produktivität einer Lichtbogen-Verdampfungsvorrichtung mit einer Magnetanordnung 66 im Vergleich zu den Bekannten gegeben ist, bei gleichzeitiger frei wählbarer Impedanz unabhängig vom Erosionszustand.

Als Erklärung für die größere Differenz, also der Breite des Erosionsgrabens, kann Folgendes angegeben werden. Der die innere Ringspule 70 peripher umgebende Polschuh 74 aus einem Material großer relativer magnetischer Permeabilität bewirkt, dass ein Großteil der magnetischen Feldlinien bei strombeaufschlagter Spule 70 durch den Polschuh 74 fließt, da dessen magnetischer Widerstand gering ist. Ungeachtet dessen müssen die Feldlinien 78 im Mittenbereich der Ringspule 70 (entlang der Mittelachse des Targets 14) fließen. Durch den magnetischen Kurzschluss des Polschuhs 74 wird ein Abdrängen der Feldlinien in Richtung der äußeren Ringspule 72 verhindert, so dass das Maximum der horizontalen Komponente des Feldes 78 zur Targetmitte gedrängt wird, d. h. der Abstand D5 wird kleiner als der nach dem Ausführungsbeispiel der Fig. 1 bis 4. Wird die äußere Ringspule 72 mit Strom beaufschlagt, tritt der entgegengesetzte Effekt ein. Der magnetische Kurzschluss des Polschuhs 76, der entlang Innenseite der äußeren Ringspule und konzentrisch zu dieser verläuft, bewirkt eine Änderung des magnetischen Flusses mit der Folge, dass die Magnetfeldlinien 80 nach außen gedrängt werden, so dass eine Vergrößerung des Abstandes der Maxima der horizontalen Komponenten des Feldes erfolgt. Dieser Abstand ist mit D6 in Fig. 6 bezeichnet. Als Ergebnis ergibt sich eine größere Differenz von D6 und D5 mit der Folge der Verbesserung der Targetausnutzung bei gleichzeitiger Erhöhung der Dynamik. Die Verlagerung der Maxima der magnetischen Feldlinie wird - wie nach dem Stand der Technik - durch entsprechendes Variieren der die Ringspulen 70, 72 beaufschlagenden Ströme bzw. deren Ausschaltens und Zuschaltens erreicht.

In der Fig. 6a ist eine Magnetanordnung entsprechend der Fig. 5 und 6 dargestellt, bei der sowohl die innere Ringspule 70 als auch die äußere Ringspule 72 mit Strom beaufschlagt sind. Die maximale horizontale Komponente des so erzeugten Magnetfeldes wandert in Abhängigkeit von der Strombeaufschlagung der Spulen 70, 72 nach innen bzw. nach außen. Im Ausführungsbeispiel ist die Maximalkomponente des wirksamen Magnetfeldes mit einem Abstand D7 eingezeichnet.

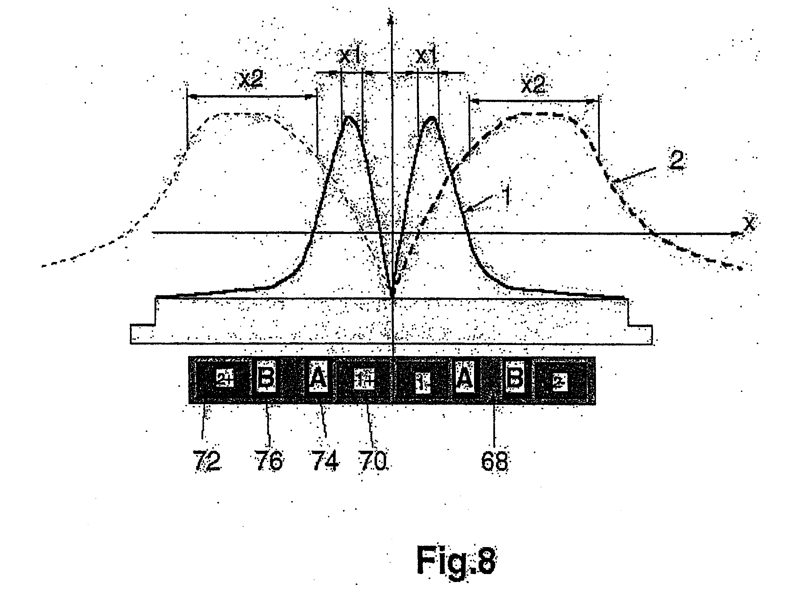

In Fig. 8 ist rein prinzipiell die horizontale Komponente der Magnetfeldstärke H gegenüber dem Target 14 ausgehend von dessen Mittelpunkt, zu dem die Ringspulen 70, 72 und die Polschuhe 74, 76 symmetrisch verlaufen, aufgetragen. Die Magnetfeldstärke, d. h. die horizontale Komponente der inneren Spule 70 ist schmal und schnell abfallend (durchgezogene Linie), wohingegen die Magnetfeldstärke - bewirkt durch die äußere Ringspule 72 - breit und langsam abfallend ausgeprägt ist. Hierdurch bedingt ergibt sich für den auf der Targetoberfläche 16 bewegenden Lichtbogenspot 18, 20 nur eine schmale Bahn mit der Folge, dass eine Verästelung der Bewegung unterbleibt und somit eine Droplet-Reduktion erzielbar ist.

Ganz allgemein ist zu Fig. 8 anzumerken, dass dieser die Veränderung der horizontalen Komponente des Magnetfeldes prinzipiell zu entnehmen ist, wie dieses vom Lichtbogen auf der Targetoberfläche wahrgenommen wird. Wegen der begünstigenden Ionisationswirkung des Magnetfeldes (horizontale Komponente) bevorzugt der Lichtbogen an Bahnen entlang zu laufen, wo höhere Felder herrschen. Weist die horizontale Komponente eines Magnetfeldes den Verlauf einer Kurve 1 gemäß Fig. 8 auf, also eine schnell abfallende Kurve, so wird sich der Lichtbogen vor allem im Bereich der Breite x1 aufhalten bzw. bewegen. Weist die horizontale Komponente des Magnetfeldes jedoch einen Verlauf 2 in Fig. 8 auf, so wird sich der Lichtbogen im Bereich x2 aufhalten, wobei x2 » x1 ist. Im Falle des Magnetfeldverlaufs der Kurve 1 wird folglich der Lichtbogen bedeutend stärker lokalisiert und kontrolliert.

Auch wird hierdurch deutlich, dass bei eingeschalteter inneren und äußeren Ringspule 70, 72 die Polschuhe 74, 76 nicht mehr von so ausschlaggebender Bedeutung sind, vielmehr diese die Wirkung des Vergrößerns der Erosionsbreite zeigen.

Vergleichsversuche zwischen Magnetanordnungen nach dem Stand der Technik gemäß der Fig. 1 und 4 und nach der erfindungsgemäßen Lehre haben zu Folgendem geführt. Bei allen Versuchen wiesen die Targets 14 eine Breite D von 140 mm auf. Die Länge betrug 750 mm. Der Abstand zwischen Targetoberfläche 16 und Oberfläche der jeweiligen Halterung 48, 68, der in Fig. 1 mit H gekennzeichnet ist, betrug 25 mm. Die zum Einsatz gelangenden inneren bzw. äußeren Ringspulen 44, 46 bzw. 70, 72 wiesen jeweils gleiche Abmessungen auf, wobei die innere Ringspule 44, 70 durch 3200 Ampere-Windungen bei einer Breite (parallel zur Targetoberfläche 16) von 22 mm und einer Höhe (senkrecht zur Targetoberfläche) von 55 mm gekennzeichnet war. Die äußere Ringspule 46, 72 wies 2500 A-Windungen bei einer Breite von 18 mm und einer Höhe von 55 mm auf. Bei der Anordnung nach den Fig. 1 bis 3, also bei allein zwei konzentrisch zueinander verlaufenden Ringspulen, wurde die horizontale Magnetfeldstärke auf 0 bis 40 Gauss im Bereich zwischen den Maxima der horizontalen Komponenten eingestellt. Es ergab sich für den Abstand D1 ein Wert von 80 mm und den Abstand D2 ein Wert von 115 mm, so dass sich eine Differenz von 35 mm ergab. Bei der Magnetanordnung 58 mit im Mittelpunkt des Targets 14 bzw. entlang dessen Mittelachse verlaufendem Permanentmagneten 60 ergab sich eine horizontale Magnetfeldstärke von 20 bis 50 Gauss zwischen den Maxima der horizontalen Komponenten der Magnetfeldlinien, wobei D4 55 mm und D2 120 mm betrug, so dass sich eine Differenz von 65 mm ergab.

Die zuvor wiedergegebenen Ergebnisse wurden grundsätzlich mit die Spulen durchfließenden Stromstärken von typischerweise 8 A bis 10 A bei 250 bis 350 Windungen erzielt.

Bei der der erfindungsgemäßen Lehre gehorchenden Magnetanordnung 66 konnte die horizontale Magnetfeldstärke im Bereich zwischen den Maxima der horizontalen Komponenten zwischen 0 und 80 Gauss variiert werden, wobei sich zwischen den Maxima die Werte D5 = 30 mm und D6 = 120 mm, also eine Differenz D6 - D5 von in etwa 90 mm, ergaben.

Versuche haben gezeigt, dass im Vergleich zu den bekannten Anordnungen auch dann verbesserte Erosionsprofile erzielbar sind, wenn allein der inneren Ringspule 70 ein diese konzentrisch umgebender Polschuh 74 eines Materials großer relativer magnetischer Permeabilität zugeordnet wurde.

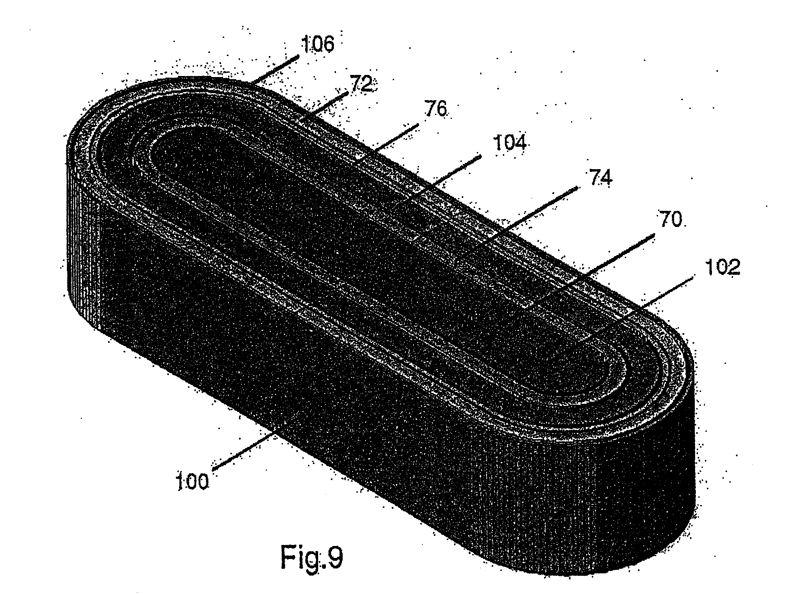

Den Fig. 9 bis 13 sind prinzipielle Darstellungen von Magnetanordnungen zu entnehmen, die der erfindungsgemäßen Lehre gehorchen. So umfasst die Magnetanordnung der Fig. 9 bis 11 ein aus Aluminium - gegebenenfalls auch Kunststoff - bestehendes als Grundkörper 100 zu bezeichnendes Gehäuse, das parallel zur Oberfläche 16 des Targets 14 angeordnet ist. Im Inneren des Grundkörpers 100 ist die innere Ringspule 70 angeordnet, die von dem diese konzentrisch umgebenden Polschuh 74 umgeben ist. Die innere Ringspule 70 umgibt im Ausführungsbeispiel einen stegförmigen Abschnitt 102 des Grundkörpers 100, der entlang der Mittelachse des Targets 14 und senkrecht zu dessen Querachse verläuft. Der innere Polschuh 74 ist wiederum von einer konzentrisch die innere Ringspule 70 und den inneren Polschuh 74 umgebenden Wandung 104 des Grundkörpers 100 begrenzt, entlang der außenseitig der der äußeren Ringspule 72 zugeordnete zweite Polschuh 74 verläuft. Schließlich ist die äußere Ringspule 72 von der Außenwandung 106 des Grundkörpers 100 umgeben.

Anzumerken ist, dass der Steg 102 möglichst schmal - praktisch gegen 0 gehend - sein sollte oder gegebenenfalls durch "Luft" oder ein nicht magnetisches Material wie Kunststoff zu ersetzen ist, um den in Fig. 5 dargestellten Abstand D5 noch weiter zu reduzieren.

Aus den Darstellungen der Fig. 9, 10 und 11 ist erkennbar, dass die Ringspulen 70, 72 und die diesen zugeordneten Polschuhe 74, 76 konzentrisch zueinander verlaufen und auf die Längs- bzw. Querachse des Targets 14 ausgerichtet sind.

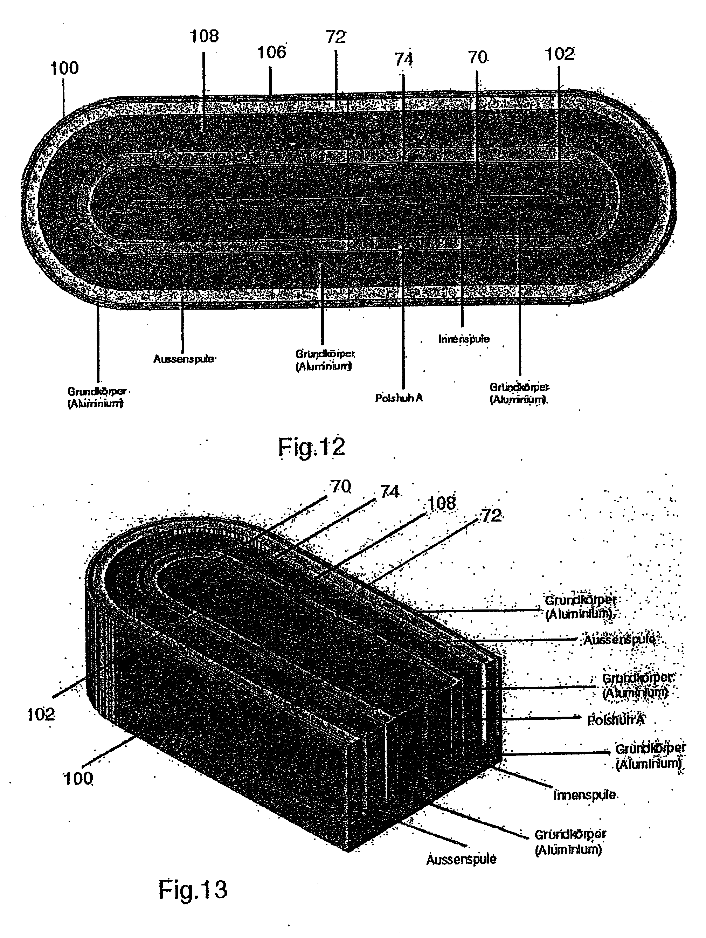

Das Ausführungsbeispiel der Fig. 12 und 13 unterscheidet sich von dem der Fig. 9 bis 11 dahingehend, dass allein der Innenspule 70 ein Polschuh 74 zugeordnet ist, wohingegen die äußere Ringspule 72 innen- und außenseitig von Abschnitten des Grundkörpers 100, also Außenwandung 106 und Zwischenwandung 108 begrenzt ist, die dem Grunde nach der Wandung 104 gemäß der Fig. 9 bis 11 entspricht.

Typische Bemaßungen der Polschuhe 74, 76 bzw. der Ringspulen 70, 72 sind wie folgt: der innere Polschuh 74 kann eine Breite von 5 bis 10 mm bei einer Höhe aufweisen, die der der inneren Ringspule 70 entspricht, also z. B. 60 mm. Bezüglich des äußeren Polschuhs 76 ist eine Breite von 3 bis 8 mm zu bevorzugen, wobei die Höhe der der äußeren Ringspule, also z. B. 60 mm betragen kann. Die Spulen 70, 72 selbst werden mit Stromstärken von vorzugsweise 0 bis 20 A beaufschlagt.

## Patentansprüche

1. Lichtbogen-Verdampfungsvorrichtung umfassend eine Anode, ein als Kathode wirkendes oder mit dieser verbundenes Target (14), eine an die Anode und die Kathode angeschlossene Spannungsquelle zur Erzeugung eines Lichtbogens bzw. Lichtbogenspots (18, 20) auf dem Target bzw. dessen freier Oberfläche (16) sowie unterhalb des Targets vorhandene eine innere und eine äußere Ringspule (70, 72) umfassende Magnetanordnung (66) zur Erzeugung eines eine Lichtbogenbewegung auf der Targetoberfläche beeinflussenden Magnetfeldes,
**dadurch gekennzeichnet,**
**dass** zumindest einer der Ringspulen (70, 72) der Magnetanordnung (66) ein im Bereich der Oberfläche (16) des Targets das Magnetfeld der Ringspule beeinflussendes Element (74, 76) hoher relativer magnetischer Permeabilität, d.h. µr >> 1, zugeordnet ist, wobei bei der inneren Ringspule (70) zugeordnetem Element dieses die innere Ringspule peripher umgibt und bei der äußeren Ringspule (72) zugeordnetem Element dieses entlang der inneren Ringspule zugewandter Fläche der äußeren Ringspule verläuft.

2. Lichtbogen-Verdampfungsvorrichtung nach Anspruch 1,
**dadurch gekennzeichnet,**
**dass** das Element (74, 76) umlaufend oder im Wesentlichen umlaufend konzentrisch zu der inneren Ringspule (70) bzw. der äußeren Ringspule (72) verläuft.

3. Lichtbogen-Verdampfungsvorrichtung nach Anspruch 1 oder 2,
**dadurch gekennzeichnet,**
**dass** das Element (74, 76) eine relative magnetische Permeabilität µr mit µr ≥ 104, insbesondere µr ≥ 106 aufweist.

4. Lichtbogen-Verdampfungsvorrichtung nach zumindest einem der vorhergehenden Ansprüche,
**dadurch gekennzeichnet,**
**dass** das Element (74, 76) aus einem ferromagnetischen Material besteht.

5. Lichtbogen-Verdampfungsvorrichtung nach zumindest einem der vorhergehenden Ansprüche,
**dadurch gekennzeichnet,**
**dass** das Element (74, 76) aus Eisen bzw. Stahl oder einer Legierung wie Permalloy besteht.

6. Lichtbogen-Verdampfungsvorrichtung nach zumindest einem der vorhergehenden Ansprüche,
**dadurch gekennzeichnet,**
**dass** der Lichtbogen aufgrund des von der Magnetanordnung (66) erzeugten Magnetfelds im Wesentlichen entlang vorgegebener Bahnen unter Vermeidung sich verzweigender Haupt- und Nebenäste auf der Targetoberfläche (16) bewegbar ist.

7. Lichtbogen-Verdampfungsvorrichtung nach zumindest einem der vorhergehenden Ansprüche,
**dadurch gekennzeichnet,**
**dass** zumindest die innere Ringspule (70) von dem Element hoher relativer magnetischer Permeabilität (µr >> 1) umgeben ist.

8. Lichtbogen-Verdampfungsvorrichtung nach zumindest einem der vorhergehenden Ansprüche,
**dadurch gekennzeichnet,**
**dass** durch die der äußeren bzw. der inneren Ringspule (70, 72) zugeordneten Elemente (74, 76) hoher relativer magnetischer Permeabilität die von den Ringspulen erzeugten und im Bereich der Targetoberfläche (16) auf den Lichtbogenspot (18, 20) einwirkenden Magnetfelder derart beeinflussbar sind, dass das von der inneren Ringspule erzeugte Magnetfeld zur Targetmitte hin und das von der äußeren Ringspule erzeugte Magnetfeld zum Targetrand hin verschiebbar ist.

9. Lichtbogen-Verdampfungsvorrichtung nach zumindest einem der vorhergehenden Ansprüche,
**dadurch gekennzeichnet,**
**dass** die Längsachse des Targets (14) und Längsachsen der Ringspule (70, 72) in einer gemeinsamen senkrecht zur Targetoberfläche (16) sich erstreckenden Ebene verlaufen.

10. Lichtbogen-Verdampfungsvorrichtung umfassend eine Anode, ein als Kathode wirkendes oder mit dieser verbundenes Target (14), eine an die Anode und die Kathode angeschlossene Spannungsquelle zur Erzeugung eines Lichtbogens bzw. Lichtbogenspots (18, 20) auf dem Target bzw. dessen freier Oberfläche (16) sowie unterhalb des Targets vorhandene zumindest eine Ringspule (70, 72) umfassende Magnetanordnung (66) zur Erzeugung eines eine Lichtbogenbewegung auf der Targetoberfläche beeinflussenden Magnetfeldes,
**dadurch gekennzeichnet,**
**dass** die zumindest eine Ringspule (70, 72) der Magnetanordnung (66) peripher von einem im Bereich der Oberfläche (16) des Targets das Magnetfeld der Ringspule beeinflussendes Element (74, 76) hoher relativer magnetischer Permeabilität, d.h. µr >> 1, umgeben ist und dass die Magnetanordnung zumindest in einer parallel zur Targetoberfläche verlaufenden x- und/oder y-Richtung verstellbar ist.

11. Lichtbogen-Verdampfungsvorrichtung nach Anspruch 10,
**dadurch gekennzeichnet,**
**dass** die Magnetanordnung (66) senkrecht zur Targetoberfläche (16) in z-Richtung verstellbar ist.

## Claims

1. An arc evaporation device comprising an anode, a target (14) acting as a cathode or connected thereto, a voltage source connected to the anode and the cathode for generating an arc or arc spot (18, 20) on the target or its free surface (16), and a magnet arrangement (66) underneath the target and comprising an inner and an outer ring coil (70, 72) for generating a magnetic field influencing an arc movement on the target surface,
wherein
at least one of the ring coils (70, 72) of the magnetic arrangement (66) is assigned an element (74, 76) of high relative magnetic permeability (µr >> 1) influencing the magnetic field of the ring coil in the area of the surface (16) of the target, where the element assigned to the inner ring coil (70) peripherally surrounds the inner ring coil and the element assigned to the outer ring coil (72) extends along that surface of the outer ring coil facing the inner ring coil.

2. Arc evaporation device according to Claim 1,
wherein
the element (74, 76) runs all round or substantially all round concentrically to the inner ring coil (70) or the outer ring coil (72).

3. Arc evaporation device according to Claim 1 or Claim 2,
wherein
the element (74, 76) has a relative magnetic permeability µr with µr ≥ 104, in particular µr ≥ 106.

4. Arc evaporation device according to at least one of the previous claims,
wherein
the element (74, 76) comprises a ferromagnetic material.

5. Arc evaporation device according to at least one of the previous claims,
wherein
the element (74, 76) comprises iron, steel or an alloy such as permalloy.

6. Arc evaporation device according to at least one of the previous claims,
wherein
the arc is movable on account of the magnetic field generated by the magnetic arrangement (66) substantially along specified paths on the target surface (16), avoiding splitting into main and secondary branches.

7. Arc evaporation device according to at least one of the previous claims,
wherein
at least the inner ring coil (70) is surrounded by the element of high relative magnetic permeability (µr >> 1).

8. Arc evaporation device according to at least one of the previous claims,
wherein
the magnetic fields generated by the ring coils (70, 72) and acting in the area of the target surface (16) on the arc spot (18, 20) can be influenced by the elements (74, 76) of high relative magnetic permeability assigned to the outer and inner ring coils (70, 72) such that the magnetic field generated by the inner ring coil can be moved towards the target centre and the magnetic field generated by the outer ring coil can be moved towards the target edge.

9. Arc evaporation device according to at least one of the previous claims,
wherein
the longitudinal axis of the target (14) and the longitudinal axes of the ring coils (70, 72) run in a common plane extending vertically to the target surface (16).

10. An arc evaporation device comprising an anode, a target (14) acting as a cathode or connected thereto, a voltage source connected to the anode and the cathode for generating an arc or arc spot (18, 20) on the target or its free surface (16) and a magnet arrangement (66) underneath the target and comprising at least one ring coil (70, 72) for generating a magnetic field influencing an arc movement on the target surface,
wherein
the at least one ring coil (70, 72) of the magnetic arrangement (66) is peripherally surrounded by an element (74, 76) of high relative magnetic permeability (µr >> 1) influencing the magnetic field of the ring coil in the area of the surface (16) of the target and wherein the magnetic arrangement is adjustable at least in an x and/or y direction running parallel to the target surface.

11. Arc evaporation device according to Claim 10,
wherein
the magnetic arrangement (66) is adjustable vertical to the target surface (16) in the z direction.

## Revendications

1. Evaporateur à arc électrique comprenant une anode, une cible (14) agissant comme cathode ou étant reliée à celle-ci, une source de tension reliée à l'anode et à la cathode pour générer un arc électrique ou un spot d'arc électrique (18, 20) sur la cible ou sur la surface libre (16) de celle-ci, ainsi qu'un ensemble d'aimants (66) disposé sous la cible et comportant des bobines annulaires intérieure et extérieure (70, 72) pour générer un champ magnétique influençant un mouvement de l'arc électrique à la surface de la cible,
**caractérisé en ce qu'**
au moins à l'une des bobines annulaires (70, 72) de l'ensemble d'aimants (66) est associé un élément (74, 76) d'une perméabilité magnétique relativement grande, c'est-à-dire µr >> 1, influençant le champ magnétique de la bobine annulaire dans la zone de la surface (16) de la cible, pour l'élément associé à la bobine annulaire intérieure (70) celui-ci entourant la bobine annulaire intérieure de manière périphérique, et pour l'élément associé à la bobine annulaire extérieure (72) celui-ci s'étendant le long de la surface de la bobine annulaire extérieure en regard de la bobine annulaire intérieure.

2. Evaporateur à arc électrique selon la revendication 1,
**caractérisé en ce que**
l'élément (74, 76) s'étend de manière circulaire ou pour l'essentiel circulaire concentriquement à la bobine annulaire intérieure (70) ou la bobine annulaire extérieure (72).

3. Evaporateur à arc électrique selon la revendication 1 ou 2,
**caractérisé en ce que**
l'élément (74, 76) présente une perméabilité magnétique relative µr de µr ≥ 104, notamment de µr ≥ 106.

4. Evaporateur à arc électrique selon au moins l'une des revendications précédentes,
**caractérisé en ce que**
l'élément (74, 76) est réalisé à partir d'un matériau ferromagnétique.

5. Evaporateur à arc électrique selon au moins l'une des revendications précédentes,
**caractérisé en ce que**
l'élément (74, 76) est en fer ou en acier ou en un alliage tel que le Permalloy.

6. Evaporateur à arc électrique selon au moins l'une des revendications précédentes,
**caractérisé en ce que**
l'arc électrique, en raison du champ magnétique généré par l'ensemble d'aimants (66), peut être déplacé pour l'essentiel le long de trajets prédéterminés à la surface de cible (16) en évitant des branches principales et secondaires ramifiées.

7. Evaporateur à arc électrique selon au moins l'une des revendications précédentes,
**caractérisé en ce qu'**
au moins la bobine annulaire intérieure (70) est entourée par l'élément à perméabilité magnétique relativement grande (µr >> 1).

8. Evaporateur à arc électrique selon au moins l'une des revendications précédentes,
**caractérisé en ce que**
les champs magnétiques générés par les éléments (74, 76) à perméabilité magnétique relativement grande associés aux bobines annulaires extérieure ou intérieure (70, 72) et agissant dans la zone de surface de cible (16) sur le spot d'arc électrique (18, 20) sont influençables de telle sorte que le champ magnétique généré par la bobine annulaire intérieure peut être déplacé vers le centre de la cible et le champ magnétique généré par la bobine annulaire extérieure vers le bord de la cible.

9. Evaporateur à arc électrique selon au moins l'une des revendications précédentes,
**caractérisé en ce que**
l'axe longitudinal de la cible (14) et des axes longitudinaux de la bobine annulaire (70, 72) s'étendent dans un plan commun situé verticalement à la surface de cible (16).

10. Evaporateur à arc électrique comprenant une anode, une cible (14) agissant comme cathode ou étant reliée à celle-ci, une source de tension reliée à l'anode et à la cathode pour générer un arc électrique ou un spot d'arc électrique (18, 20) sur la cible ou sur la surface libre (16) de celle-ci, ainsi qu'un ensemble d'aimants (66) disposé sous la cible et comportant au moins une bobine annulaire (70, 72) pour générer un champ magnétique influençant un mouvement de l'arc électrique à la surface de la cible,
**caractérisé en ce qu'**
au moins une bobine annulaire (70, 72) de l'ensemble d'aimants (66) est entourée de manière périphérique par un élément (74, 76) à perméabilité magnétique relativement grande, c'est-à-dire µu >> 1, influençant le champ magnétique de la bobine annulaire dans la zone de la surface (16) de la cible, et l'ensemble d'aimants peut être déplacé du moins dans une direction x et/ou y s'étendant parallèlement à la surface de la cible.

11. Evaporateur à arc électrique selon la revendication 10,
**caractérisé en ce que**
l'ensemble d'aimants (66) peut être déplacé verticalement à la surface de cible (16) dans la direction z.
